# EUROPEAN PATENT SPECIFICATION

(11) **EP 4 008 444 B1**
(45) Date of publication and mention of the grant of the patent: **10.09.2025**
(21) Application number: 20216239.2
(22) Date of filing: 21.12.2020
(51) Int. Cl.: B09B 3/00, B09B 5/00, C22B 1/00, C22B 7/00, C22B 11/00, B29B 17/02, H05K 1/00, B03C 1/30, H05K 3/22, C22B 11/02, B29B 17/04, B29B 17/00, B03C 3/017, B09B 3/80, B29L 31/34, B09B 101/17, B09B 101/15

(54) **ECO-FRIENDLY METHOD FOR RECYCLING ELECTRONIC WASTE**
UMWELTFREUNDLICHE VERFAHREN ZUR RECYCLING VON ELEKTRONISCHEN ABFÄLLEN
MÉTHODE ÉCOLOGIQUE DE RECYCLAGE DES DÉCHETS ÉLECTRONIQUES

(30) Priority: 07.12.2020 PT 2020116922
(43) Date of publication of application: 08.06.2022
(73) Proprietor: Universidade Do Porto, 4099-002 Porto (PT); Universidade de Aveiro, 3810-193 Aveiro (PT)
(72) Inventor: Soares, Helena Maria Vieira Monteiro, 4200-465 Porto (PT); Marques, António Torres, 4200-465 Porto (PT); Bastos, Margarida Maria da Silva Monteiro, 4200-465 Porto (PT); Martelo, Liliana Marques, 4200-465 Porto (PT); Sousa, Paulo Miguel Soares de, 4200-465 Porto (PT); Dias, Ana Cláudia Relvas Vieira, 3810-193 Aveiro (PT); Arroja, Luís Manuel Guerreiro Alves, 3810-193 Aveiro (PT)
(74) Representative: Pereira da Cruz, Joao

(56) References cited:
- US-A1- 2017 362 682
- US-B2- 7 867 317

## Description

### Field of the Invention

The present invention relates to the field of electronics, chemical engineering and environment, particularly to the field of electronic waste management and methods for recycling valuable metals.

The present invention relates to a method for recovering valuable metals contained in waste electronic material, according to claim 1.

Dependent claims refer to preferred embodiments of the invention.

### Background of the Invention

Electronic waste is created when an electronic product is discarded after the end of its useful life. The rapid expansion of technology and the consumption driven society results in the creation of a very large amount of e-waste in every minute.

Electronic waste is considered the fastest-growing waste stream in the world with million tonnes of waste generated every year. Waste electrical and electronic equipment (WEEE) is generated globally, with an increasing annual growth rate¹.

Nowadays, the production of modern Electric and Electronic Equipment (EEE) requires the use of scarce and expensive resources, as it is the case of gold. According to industry information's, it is estimated that, currently, around 300 tons of Au are used in the production of new printed circuit boards (PCBs). Therefore, considering the high price of gold, the isolation of this raw material from obsoletes PCBs is a worldwide attractive business niche for the recycling companies.

WEEE contain 3-5% of PCBs, which are the most valuable part of WEEE. PCBs are constituted by a heterogeneous mixture of metals, ceramic and plastics, such as fiber glass. Among these fractions, the driving force for recycling waste PCBs is the recovery of metals, particularly precious metals (PMs), such as gold.

Electronic scrap components contain potentially harmful materials such as lead, cadmium, beryllium, or brominated flame retardants (BFRs). Recycling and disposal of electronic waste may involve significant risk to health of workers and their communities.

Rapid changes in technology, changes in media (tapes, software, MP3, etc.), falling prices, and planned obsolescence have resulted in a fast-growing surplus of electronic waste around the globe.

Currently, in developed countries, the recovery of PMs from PCBs is mainly performed in the smelters via pyrometallurgy followed by hydrometallurgical refining but this technology presents important drawbacks, such as the loss of PMs, generation of hazardous emissions (namely dioxins plus flue dust containing metals) and is very energy intensive.

From the methods known from the state of the art to recycle electronic waste, the following were considered to be relevant to highlight the problem solved by the present invention.

Document JP2001064735A discloses a method that recovers gold and other PMs from waste PCBs of waste mobile phones. The invention in JP2001064735A relates to a method and a system for collecting gold and other PMs from a portable telephone set or the like. In JP2001064735A, the cut is referred to as "crushing", indicating that there is not a specific technique to cut the PCBs. Additionally, in JP2001064735A the separation of metals is obtained via a molten metals furnace, which operate at very high temperatures.

The method of crushing the waste material, namely PCB's, has several disadvantages, namely forming potentially harmful dusts, losing part of the valuable metals in the electronic waste material, namely gold and platinum and being environmentally unfriendly due to the high energy waste.

Document WO 2010/055489 relates to a method for treating materials containing a mixture of plastic and metal materials in electronic waste. This method includes crushing the material (20 to 30 mm) to be treated following a pyrolysis (between 300 and 600 °C) of the crushed material. After the pyrolysis process, a first magnetic separation is performed to separate the ferrous metal fraction (iron and iron derivatives) from the non-ferrous material (aluminum and zinc). Subsequently, a second magnetic separation is performed to the non-ferrous fraction to separate the non-ferrous metal fraction from the non-magnetic residue (copper, lead, tin, fiber glass and PMs, such as Au and Pt). This document suggests the recovery of the PMs, namely gold, contained in the non-magnetic fraction. It is described the use of sulphuric acid followed by electrowinning to recover copper. This document does not disclose any specific procedure or method to recover a valuable metal, namely gold, from the electronic waste.

Document US 7867317 discloses a method for recovering valuable metals contained in waste PCBs. The method uses organic solvents for liberating metal and plastic laminated in waste PCBs and then separation and recovery of the liberated metal components using an electrostatic separation process. The process includes:
(a) heating and stirring the waste PCBs after putting them into an organic solvent.
(b) cleaning and optionally drying the metal and the plastic after separating the metal and the plastic by filtering them out.
(c) recovering the metal from a mixture of the metal and the plastic dried using an electrostatic separation process.

In document US7867317, the optimum condition was described as cutting the waste of PCBs in size of 7 mm, 5mm, and 3mm and the cut waste of PCBs put into a beaker of N,N-Dimethyl formamide (DMF) (solid/liquid ratio of 1:10). The temperature used during the process was 130° C and the stirring was performed for 1 hour at a revolution velocity of 900 rpm. Subsequently, the dried components pass through the electrostatic separation process, thereby obtaining the metal recovery rate of 99.99 %. The separation is performed by an electrostatic separation process allowing to separate only metals and non-metals, not specifying the amount of the gold recovered or even in what way they can separate the gold from other base-metals present in the metal fraction.

Unlike document JP2001064735A, the method of the present invention presents a different cut of the waste of PCBs focused on the connecting terminals containing the gold fingers from the PCBs that allows an increase in the amount of recovered gold. Additionally, the method of the present invention allows complete separation of gold fingers, copper laminates and plastic fraction through magnetic separation.

Unlike WO2010/055489, the method of the present invention leads to a complete delamination of the several constituent layers of PCBs or other electronic waste allowing to obtain copper layers separated from the gold fingers and the plastic fraction.

The magnetic separation performed in the method of the present invention allows to easily separate the metallic fraction of the electronic waste, namely gold fingers, which contains the PM, namely gold, from the copper foils and the plastic fraction. In the present method, it was found that the gold fingers can be magnetized by an external magnetic field and, thus, being easily separated from the other components (copper layers and fiber glass) of the mixture.

In a surprising way, the method of the present invention performs a different cut of the waste of PCBs or other electronic waste. The cut of the present invention is focused on the connecting terminals containing the gold fingers from the electronic waste, particularly PCBs, allowing an increase in the amount of gold recovered. Secondly, the present method is performed in a low-pressure reactor. The increase of the pressure in the organic swelling process decreases the time of the complete delamination of the metal and plastic laminates in waste PCBs. In the present method, the complete separation of the copper laminates, the gold fingers and the plastic fraction occur preferably in 30-20 minutes, half the time reported in document US7867317 (1 h).

In an embodiment, the optimum conditions of the present invention were obtained using different organic solvents, preferably N-methyl-2-pyrrolidone (NMP) and dimethyl sulfoxide (DMSO) accompanied by a gold fingers recovery ratio of 98.3 and 97.1 % respectively, via this organic swelling pressure-assisted and magnetic separation process. Additionally, the method of the present invention regards the separation process of the obtained wet or dried metal and plastic fractions after the organic swelling. In the present method, the gold fingers can be easily separated and recovered from the copper laminates and the plastic fraction through a magnetic separation since they possess magnetic properties.

Documents CN 109022814 A and CN 111041207 A disclose different methods for recycling gold from waste gold plated circuit boards.

Documents CN1313208C, CN109609767A and CN101100706A are also outlined to enhanced the problem solved by the present invention.

The most critical step in recycling PCBs is to separate metallic components from the non-metallic components through removing or degrading the organic materials. Several recycling technologies using mechanical, chemical and thermal approaches have been searched for that purpose. Nowadays, the available technologies do not allow to recover gold fingers plus copper in an efficient and environmentally friendly manner and with a lower carbon footprint. Milling or pulverization are common methods for that, but they generate a large amount of dusts and there is also a high energy consumption and losses of PMs. Also, pyrometallurgical followed by hydrometallurgical refining processes, used in the smelters, present important drawbacks as for example loss of PMs, generation of hazardous and toxic emissions, like dioxins and furans substances, and high energy consumption ²

A friendly method for the complete delamination of waste PCBs consists in dissolving the brominated epoxy resin (BER) in an appropriate organic solvent ^{3,4,5}. This dissolution allows to destroy the reinforced multi-layered PCBs structure and, thus, the enveloped metals are liberated.

One of the main advantages of this method is that the BER does not decompose and does not produce toxic gases. However, the most critical point (yet to be solved) corresponds to the subsequent efficient separation of the various metallic elements (gold fingers and copper laminates) from the non-metallic fraction (glass fiber), which is crucial if the desirable aim is to recycle selectively all valuable components, in particular gold.

These facts are outlined to enhance the problem solved by the present invention.

### General Description of the Invention

The present invention discloses a new method for recovering gold from PCBs, according to claim 1, by separating several polymeric layers using organic solvents and separating the non-metallic and other base metal components from gold fingers using magnetic separation with sieving.

In an embodiment, the choice of the waste PCBs was targeted at random access memories (RAMs), graphics and soundboards, and ethernet boards of WEEE due to the high concentration of gold on their composition.

The new methodology developed by the inventors is addressed to fill the need for a more efficient and environmental-friendly process for recycling valuable metals from electronic waste, in particular for recycling gold, copper and glass fibers from waste PCBs.

End-life PCBs may contain up to 60 different chemical elements and have a metal content as high as 40% by weight. PCB is a thin board made of epoxy resin and glass fiber, which is coated with a layer of thin copper laminate. The metals in PCB substrate are in the forms of copper laminates (10-27% of PCB mass) and the coatings [tin, nickel, gold, silver, etc.] on the surface of copper layers, pins and holes that increase conductivity and oxidation resistance. The levels of PMs vary considerable depending on the age of the device. The basic structure of the PCBs is the copper layer, glass fiber-reinforced epoxy resin and several metallic materials.

The present invention relates to a new method for recovering gold from PCBs, by separating several non-metallic layers using an organic solution and separating non-metallic components and copper laminates from gold fingers using magnetic separation with sieving.

In an embodiment, the choice of the waste PCBs is targeted at random access memories (RAMs), graphics and sound boards, and ethernet boards from personal computers and laptops due to the high concentration of gold on their composition⁶. The person skilled in the art will acknowledge the existence of other targets as for example processors for laptops, desktops, cell phones, servers, discs and the like. The scope of the present invention is not limited to the components herein described.

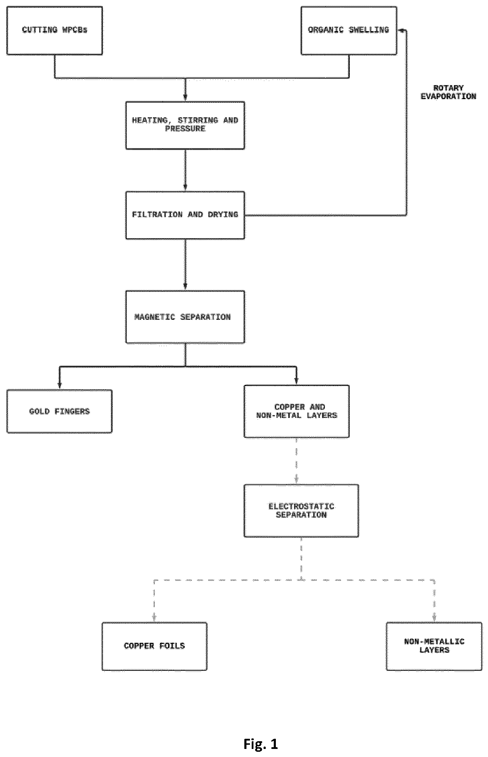

In an embodiment, the method for liberating and recovering gold from wastes PCBs includes, as shown in Figure 1:
a) cutting the connecting terminals containing gold fingers from the PCBs using a mechanical process (for example a guillotine or a rotary knife),
b) optionally placing the cut PCBs connected terminals in an overnight process with stirring in an appropriate organic solvent,
c) performing an organic swelling in a low-pressure reactor with heating and stirring and finally,
d) using magnetic separation process followed by sieving to recover the gold fingers from a mixture of the copper laminates and the NMF, optionally dried previously.

In optimum conditions, the global yield recovery of gold fingers ranged from 97.1 to 98.3 %.

Other important additional advantages of this process when compared with the main current technologies, is based on the simplicity, rapidity and environmentally friendly character of the developed method to isolate valuable metals from electronic waste. Additionally, it does not require sophisticated equipment as for example complex air extraction systems.

Furthermore, the combination of the physical and chemical processes proposed in this invention leads to an easy scale-up technology for industrial application.

Taking this into account, the new method of the present invention allows separating the non-metallic and the two main metallic components (gold fingers and copper laminate) from the waste PCBs by separating the several laminated layers via simple use of organic solvents and obtaining a high gold recovery ratio, via this organic swelling pressure-assisted and magnetic separation process.

The method of the present invention has the advantages to provide a smart process that can minimize the generation of wastes, namely, dusts and wastewaters containing metals, energy consumption and equipment space. Furthermore, other important additional advantages of the present method, when compared with the main current technologies, is based on the simplicity, time and environmentally friendly character of the process developed to recover gold with high yield from the wastes PCBs.

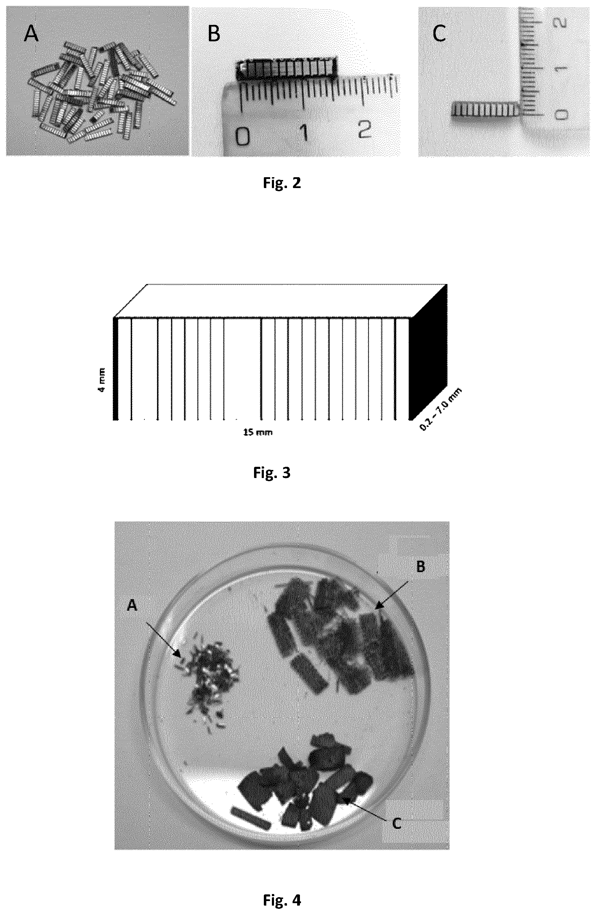

The technical feature of cutting the connecting terminals containing valuable metals from electronic waste using a mechanical process, for example a guillotine, a rotary knife or a grinder is of extreme relevance. The specific cut (Figures 2 and 3) of the connecting terminals containing valuable metals from the electronic waste allows the pre-concentration of the gold from the overall amount of electronic waste and benefits the separation and recovery in the subsequent steps. A different cut of the electronic waste, such as PCBs waste, focused on the connecting terminals containing the gold fingers from the waste allows an increase in the amount of recovered gold or other valuable metal.

The optional technical feature consists in placing the cut PCBs or other electronic waste connected terminals in a pre-swelling process with stirring in an appropriate organic solvent. The specific cut performed in the electronic waste is an important aspect of the present invention since it provides a high contact surface with the organic solvent during the subsequent swelling step in the low-pressure reactor, allowing the effective separation between the gold fingers or other valuable metal layers from the copper laminates and plastics fraction under mild conditions, preferably in less than one hour, more preferably in less than 45 minutes, even more preferably in less than 30 minutes, and most preferably in 20 minutes.

The technical feature of performing an organic swelling in a low-pressure reactor with stirring is of the utmost importance. The swelling step using organic solvents for promoting the separation of the metallic and non-metallic parts of the electronic waste belongs to the state of the art, but the optimized conditions of the present invention, namely the duration of the swelling step and the dimensions of the cut pieces provide an unexpected result. The method of the present invention is performed in a low-pressure reactor and it achieves complete separation in half the time of the usual processes known from the state of the art.

The technical feature of isolating gold fingers from a mixture of the copper foils and the fiber glass using a magnetic separation process with sieving is also very relevant. The separation process proposed for gold fingers recovery from the non-metal and other base-metal components after organic swelling using magnetic separation with sieving is novel and inventive and provides an efficient, clean and easy way to separate the gold layers from the mixture containing copper and plastic layers.

For "low-pressure reactor" it shall be understood as a sealed vessel (reactor) in which the process of the present invention is performed under enough pressure to promote the technical effect of complete delamination of the waste PCBs. In a particular embodiment of the present invention, with no limitation of the scope of the same, for "low-pressure reactor" it shall be understood that a reactor performing the process of the present invention under a pressure from 1 to 10 atm is covered. Nevertheless, this parameter shall be interpreted in the broadest manner in the sense that the pressure depends on the volume of the sealed vessel (reactor), the volume of the solvent and temperature, the type of solvent itself and all these factors combined.

For "mechanical process" it shall be understood any mechanical process suitable for performing the cut of electronic waste, preferably PCB's.

For "pre-swelling" it shall be understood any type of swelling performed before the swelling step of the process of the present invention.

For "metal components" it shall be understood the metallic fraction of the electronic waste.

For "organic solvent" it shall be understood any carbon-based substance capable of dissolving or dispersing one or more other substances. By "organic solvent" it shall also be understood the mixture of two or more organic solvents as well as the mixture of different functional groups in the same molecule of organic solvent.

For "polymeric components" it should be understood any plastic, resin and fiber glass components.

For "non-metallic fraction" it should be understood any non-metallic components, such as fiber glass and polymeric components.

### Detailed Description of Figures

**Figure 1****.** is a flow diagram of the overall procedure for recovering gold fingers (plus copper layers and other non-metallic fraction) from the waste PCBs according to the present invention.
**Figure 2****.** Connector's terminals containing gold fingers before treatment (A); approximate length (B) and width (C) of connector's terminals containing gold fingers before treatment.
**Figure 3****.** Schematic drawing of a cut and its average length (15 mm), average width (0.2-7.0 mm) and its average height (4 mm).
**Figure 4****.** Separated components obtained after the swelling of the waste PCBs constituted by glass fibers (B), gold (A) fingers and copper laminates (C) using NMP as solvent. The experimental conditions were solid/liquid ratio of 1:10, waste PCB area/size of 60 mm² /15×4 mm, at 150 °C for 30 min with pressure, without overnight and velocity of 1000 rpm.

### Detailed Description of the Invention

After cutting the connecting terminals from the waste PCBs into an appropriate size using a cutting tool, such as a grinder, a knife rotary or a guillotine, the cut pieces are putted into an appropriate organic solvent listed below and then optionally stirred (pre-swelling process), which will help the liberation of the metallic and non-metallic components from the waste PCBs in the subsequent swelling process. In the specific case of the results presented herein, the cut waste of PCBs is preferably put into the organic solvent (in a solid/liquid ratio of 1:10 g/mL or preferentially 1:5 g/mL) for an optional period of 17 hours with a stirring of 600 rpm.

The mixture resultant from the optional pre-swelling (pre-swollen cut waste of PCBs together with the organic solvent) or the cut waste of PCBs (in a solid/liquid ratio of 1:10 g/mL or preferentially 1:5 g/mL) is preferably put into a low-pressure reactor using stirring to efficiently cause the dissolution of the BER using one or a mixture of organic solvents. The solvents can be chosen among others: amides [such as dimethylformamide (DMF), dimethylacetamide (DMA), hexamethylphosphoramide (HMPA)], ketones [such as, methylethylketone (MEK), cyclohexanone, cyclopentanone, acetone], lactones [such as γ-butyrolactone, γ-caprolactone, γ-valerolactone, ε-caprolactone], sulfoxides [such as, dimethyl sulfoxide (DMSO), diethyl sulfoxide], lactamas [such as N-methylpyrrolidone (NMP), N-ethylpyrrolidone, N-propylpyrrolidone, N-buthylpyrrolidone], carboxylic acids [such as acetic acid], sulfonic acids [such as methanesulfonic acid], alcohols [such as, tetrahydrofurfuryl alcohol (TFA), propan-2-ol, butan-1-ol, ethanol], esters [such as, dimethyl malonate, ethyl acetate, butyl acetate, terc-butyl acetate, methyl ethanesulfonate], aromatics solvents [such as, phenol, benzene, m-cresol, N,N-difluorobenzene], amines [such as, pyridine, N,N'-diethyl-1,2-ethanediamine, 4-methylpyridine, 3-methyl-1-hexanamine] , nitrile [such as, acetonitrile, decane nitrile], ethers [such as dioxane, tetrahydrofuran (THF)] and ionic liquids [such as 1-n-butyl-3-methylimidazolium chloride, 1-ethyl-3-methylimizadolium tetrafluoroborate]. Additionally, not excluding solvents with mixtures of functional groups, such as diacetone alcohol, ethyl acetoacetate, ethyl pyruvate.

The stirring is preferentially but not restricted performed at a rotation rate ranging from 600 to 1000 rpm at a temperature range between 60 °C to 250 °C, depending on the boiling point (Bp) of the solvent, with pressure during a sufficient period of time, in the specific case of the results presented, 30 minutes were used to efficiently cause the optimum dissolution of the BER using the organic solvent and, consequently, the liberation of the non-metallic and metallic layers.

After swelling is performed, it is preferable to recover the metallic and non-metallic fractions, along with collecting the organic solvent via solid-liquid separation step. After the solid-liquid separation, the solid fraction containing the metallic and non-metallic components recovered are subject to an optional drying step, and then the gold laminates are separated from the copper foils and the non-metallic fraction using magnetic separation process with sieving. The separation process is carried out using magnetic separation.

In an embodiment, the sieving process allows separating the large fibers using sieves preferably from 0.707 to 2mm, remaining the recovered gold fingers separated.

In an embodiment, for the remaining components (fiberglass, copper and other base metals), the copper and other base metals are separated from the non-metallic fraction recovered using an established process, such as electrostatic separation. In a preferred embodiment, the used organic solvent is recycled by evaporation.

### EXAMPLES

### Example 1 - Delamination of the multi-layered structure of waste PCBs

Table 1 summarizes the gold fingers recovery yield results achieved according to the present method, after organic swelling with each described solvent followed by magnetic separation.

**Table 1. Gold fingers recovery yield at the end of the proposed method with various organic solvents studied. All experiments were performed using stirring ranging from 600 to 1000 rpm velocity with pressure for 30 minutes for a solid/liquid ratio of 1:10 g/mL (* solid/liquid ratio of 1:5 g/mL).**

| **Organic Solvents** | **Gold fingers Recovery rate (%)** | **Temperature (°C)** | **Overnight** |
|---|---|---|---|
| DMF | 60.6 | 180 | Yes |
| DMA | 85.5 | | |
| Cyclohexanone | 78.8 | | |
| γ-butyrolactone | 73.3 | | |
| DMSO | 97.1 | | |
| | 96.6 | | No |
| | 89.6* | | |
| | 95.1 | 150 | |
| NMP | 98.3 | 180 | Yes |
| | 97.4 | | No |
| | 94.1* | | |
| | 94.4 | 150 | |

The present results have shown that high yield recoveries of the gold fingers and complete delamination was achieved with the DMSO and NMP solvents (Figure 4), NMP being a more appropriate solvent than DMSO. This can be due to the physical, chemical and structural properties of the NMP, although both being aprotic polar solvents.

### Example 2

The connecting terminals from the waste PCBs are cut in a size area of 60 mm² (15×4 mm) using a guillotine, 3g of the cut waste of PCBs is put into 30 mL of NMP (solid/liquid ratio 1:10 g/mL) into a low-pressure reactor made of stainless steel using two magnetic helical stirrers. The temperature is kept at 180 ºC and the resultant pressure achieved was about 3 atm. The stirring is performed for 30 minutes at a revolution velocity of 600 rpm. After the stirring finished, the swollen residue is separated from the organic solution via the filtering process and then dried. Subsequently, the dried residue is put into a flask under a stir plate for the separation process. The separation process is carried out using a magnetic stirrer at a revolution velocity of 600 rpm for 30 minutes. The gold fingers attracted to the magnet are then recovered. Additionally, to increase the recovery rate of the gold fingers, they are passed in a sieve with 2 mm and successively to another one of 0.707 mm. At the end of this method, the gold fingers are recovered with a rate of 98.3 % plus a mixture of fiber glass and copper layers.

### Example 3

The connecting terminals from the waste PCBs are cut in a size area of 60 mm² (15×4 mm) using a guillotine, 3g of the cut waste of PCBs is put into a goblet containing 30 mL of DMSO (solid/liquid ratio 1:10 g/mL) and, then, stirred at a rotation of 600 rpm for 17 hours (pre-swelling). After the pre-swelling, the content of the goblet is transferred into a low-pressure reactor made of stainless steel using two magnetic helical stirrers. The temperature is remained at 180 °C and the resultant pressure achieved was about 3 atm. The stirring is performed for 30 minutes at a revolution velocity of 900 rpm. After that, the swollen residue is separated from the organic solution via a solid-liquid separation and the solid is dried at a temperature of 80 °C in a vacuum oven. Subsequently, the dried residue is put into a flask under a stir plate for the separation process. The separation process is carried out using a magnetic stirrer at a revolution velocity of 600 rpm for 30 minutes. The gold fingers are attracted to the magnet and, thus, recovered from the remaining mixture. Additionally, to increase the recovery rate of the gold fingers, the dried residue is passed to a sieve with 2 mm and successively to another one of 0.707 mm. At the end of this method, the gold fingers are recovered with a rate of 97.1% plus a mixture of fiber glass and copper layers.

It is an object of the present invention to apply the process of the present invention at an industrial level, being within the scope of the present disclosure sieves with diameters other than the aforementioned, in particular from 0.5 to 5 mm.

Scaling the process of the present invention to an industrial level shall require the necessary adaptations, which a skilled person in the art should be aware of, without requiring the use of inventive skills.

Concerning magnetic separation of the gold fingers from the fiber glass and the copper laminates is easily achieved using a novel method based on magnetic separation with sieving. This is possible due to the presence of nickel in the composition of the gold fingers, which presents magnetic properties and can be attracted to a magnet and be easily separated from the mixture of fiber glass and copper laminates, as it is shown in Figure 4.

In an embodiment, the present disclosure describes a new process to recycle valuable metals, particularly gold fingers from waste electronic material, particularly PCBs. For this purpose, the combination of a swelling step of the cut connecting terminals containing gold from the waste PCBs, performed in a closed reactor, followed by the magnetic separation with sieving of the swollen mixture provides a rapid, efficient clean and easy way to separate the gold fingers from the other components (without dust formation). Subsequently, copper laminates can be recovered from the non-metallic fraction by applying an electrostatic separation process of the remaining mixture.

As will be clear to one skilled in the art, the present invention should not be limited to the embodiments described herein, and a number of changes are possible which remain within the scope of the appended claims.

Of course, the preferred embodiments shown above are combinable, in the different possible forms, being herein avoided the repetition all such combinations.

### REFERENCES

1. Singh, N., Duan, H., Tang, Y. Toxicity evaluation of E-waste plastics and potential repercussions for human health. Environ. Int. 137, 105559 (2020).
2. Attah-Kyei, D., Akdogan, G., Dorfling, C., Zietsman, J., Lindberg, D., Tesfaye, F., Reynolds, Q., Investigation of waste PCB leach residue as a reducing agent in smelting processes. Miner. Eng. 156, (2020).
3. Zhu, P., Chen, Y., Wang, L. Y., Zhou, M. & Zhou, J. The separation of waste printed circuit board by dissolving bromine epoxy resin using organic solvent. Waste Manag. 33, 484-488 (2013).
4. Verma, H. R., Singh, K. K. & Mankhand, T. R. Dissolution and separation of brominated epoxy resin of waste printed circuit boards by using di-methyl formamide. J. Clean. Prod. 139, 586-596 (2016).
5. Verma, H. R., Singh, K. K. & Mankhand, T. R. Liberation of metal clads of waste printed circuit boards by removal of halogenated epoxy resin substrate using dimethylacetamide. Waste Manag. 60, 652-659 (2017).
6. Kaya, M. Electronic Waste and Printed Circuit Board Recycling Technologies (BOOK). (2019). doi:10.1007/978-3-030-26593-9.

## Claims

1. Process for recovering gold from printed circuit boards (PCBs) comprising the steps of:
a) cutting the terminals from the PCBs comprising a metallic fraction and a non-metallic fraction using a mechanical process, wherein the cut is performed on the connecting terminals of the PCBs;
b) optionally placing the cut PCBs connecting terminals in a pre-swelling process with an organic solvent chosen from the following list: amides, dimethylformamide, dimethylacetamide, hexamethylphosphoramide, ketones, methylethyl ketone, cyclohexanone, cyclopentanone, acetone, lactones, γ-butyrolactone, γ-caprolactone, γ-valerolactone, ε-caprolactone, sulfoxides, dimethyl sulfoxide, diethyl sulfoxide, lactamas, N-methylpyrrolidone, N-ethylpyrrolidone, N-propylpyrrolidone, N-buthylpyrrolidone, carboxylic acids, acetic acid, sulfonic acids, methanesulfonic acid, alcohols, tetrahydrofurfuryl alcohol, propan-2-ol, butan-1-ol, ethanol, esters, dimethyl malonate, ethyl acetate, butyl acetate, terc-butyl acetate, methyl ethanesulfonate, aromatics solvents, phenol, benzene, m-cresol, N,N-difluorobenzene, amines, pyridine, N,N'-diethyl-1,2-ethanediamine, 4-methylpyridine, 3-methyl-1-hexanamine, nitrile, acetonitrile, decane nitrile, ethers, dioxane, tetrahydrofuran, ionic liquids, 1-n-butyl-3-methylimidazolium chloride, 1-ethyl-3-methylimizadolium tetrafluoroborate, solvents with mixtures of functional groups, diacetone alcohol, ethyl acetoacetate, ethyl pyruvate and combinations thereof, preferably dimethylformamide, dimethylacetamide, cyclohexanone, γ-butyrolactone, dimethyl sulfoxide, N-methyl-2-pyrrolidone or combinations thereof and even more preferably N-methyl-2-pyrrolidone, dimethyl sulfoxide or a mixture thereof, preferably with stirring;
c) performing an organic swelling of the cut PCBs with an organic solvent chosen from the following list: amides, dimethylformamide, dimethylacetamide, hexamethylphosphoramide, ketones, methylethylketone, cyclohexanone, cyclopentanone, acetone, lactones, γ-butyrolactone, γ-caprolactone, γ-valerolactone, ε-caprolactone, sulfoxides, dimethyl sulfoxide, diethyl sulfoxide, lactamas, N-methylpyrrolidone, N-ethylpyrrolidone, N-propylpyrrolidone, N-buthylpyrrolidone, carboxylic acids, acetic acid, sulfonic acids, methanesulfonic acid, alcohols, tetrahydrofurfuryl alcohol, propan-2-ol, butan-1-ol, ethanol, esters, dimethyl malonate, ethyl acetate, butyl acetate, terc-butyl acetate, methyl ethanesulfonate, aromatics solvents, phenol, benzene, m-cresol, N,N-difluorobenzene, amines, pyridine, N,N'-diethyl-1,2-ethanediamine, 4-methylpyridine, 3-methyl-1-hexanamine, nitrile, acetonitrile, decane nitrile, ethers, dioxane, tetrahydrofuran, ionic liquids, 1-n-butyl-3-methylimidazolium chloride, 1-ethyl-3-methylimizadolium tetrafluoroborate, solvents with mixtures of functional groups, diacetone alcohol, ethyl acetoacetate, ethyl pyruvate and combinations thereof, preferably dimethylformamide, dimethylacetamide, cyclohexanone, γ-butyrolactone, dimethyl sulfoxide, N-methyl-2-pyrrolidone or combinations thereof and even more preferably N-methyl-2-pyrrolidone, dimethyl sulfoxide or a mixture thereof, in a low-pressure reactor, wherein the pressure is from 1 to 10 atm with heating and stirring, therefore obtaining a mixture;
d) solid-liquid separation of the mixture, the solid fraction of the mixture comprising the metallic and non-metallic fractions being subject to an optional drying step ;
e) separation of gold from the metallic and non-metallic fractions using magnetic separation;
f) and sieving.

2. Process according to claim 1, wherein the ratio of the PCBs:solvent is 1:10 g/mL, preferably 1:5 g/mL, more preferably 1:3 g/mL and even more preferably 1:2 g/mL.

3. Process according to any of the previous claims, wherein said gold is gold fingers.

4. Process according to any of the previous claims wherein the mechanical process comprises a guillotine, a rotary knife, a grinder or any other suitable cutting apparatus.

5. Process according to any of the previous claims wherein stirring in step b is performed from 15 hours to 20 hours, preferably 17 hours.

6. Process according to any of the previous claims wherein the step of performing an organic swelling in the low-pressure reactor is carried out in less than one hour, more preferably in less than 45 minutes, even more preferably in less than 30 minutes and even more preferably in 20 minutes.

7. Process according to any of the previous claims, wherein the step of performing an organic swelling in a low-pressure reactor is carried out at a stirring speed from 400 to 1200 rpm, preferably from 600 to 1000 rpm.

8. Process according to any of the previous claims, wherein the step of performing an organic swelling in a low-pressure reactor is carried out at a temperature from 40 °C to 300 °C, preferably from 60 °C to 250 °C.

9. Process according to any of the previous claims, wherein the sieving step is carried out with sieves from 0.5 to 5 mm, preferably from 0.7 to 2mm.

10. Process according to any of the previous claims comprising an additional step of electrostatic separation process for isolating base metals, preferably copper foils, from the non-metallic fraction.

11. Process according to any of the previous claims, wherein the step of separating the non-metallic from the metallic fractions of the PCBs is carried out by separating polymeric components from non-metallic laminated layers, wherein the metallic components are gold fingers, copper laminates or combinations thereof.

12. Process according to any of the previous claims, wherein a gold fingers recovery yield is above 80%, more preferably above 90% and even more preferably above 95%.

## Patentansprüche

1. Verfahren zur Rückgewinnung von Gold aus gedruckten Leiterplatten (PCBs), das die folgenden Schritte umfasst:
a) Schneiden der Anschlussklemmen von den PCBs, die einen metallischen Anteil und einen nichtmetallischen Anteil umfassen, mit einem mechanischen Verfahren, wobei der Schnitt an den Anschlussklemmen der PCBs durchgeführt wird;
b) optionales Unterziehen der zugeschnittenen PCBs Anschlussklemmen einem Vorquellprozess mit einem organischen Lösungsmittel, ausgewählt aus der folgenden Liste: Amide, Dimethylformamid, Dimethylacetamid, Hexamethylphosphoramid, Ketone, Methylethylketon, Cyclohexanon, Cyclopentanon, Aceton, Lactone, γ-Butyrolacton, γ-Caprolacton, γ-Valerolacton, ε-Caprolacton, Sulfoxide, Dimethylsulfoxid, Diethylsulfoxid, Lactamen, N-Methylpyrrolidon, N-Ethylpyrrolidon, N-Propylpyrrolidon, N-Buthylpyrrolidon, Carbonsäuren, Essigsäure, Sulfonsäuren, Methansulfonsäure, Alkohole, Tetrahydrofurfurylalkohol, Propan-2-ol, Butan-1-ol, Ethanol, Ester, Dimethylmalonat, Ethylacetat, Butylacetat, Terzbutylacetat, Methylethansulfonat, aromatische Lösungsmittel, Phenol, Benzol, m-Kresol, N,N-Difluorbenzol, Amine, Pyridin, N,N'-Diethyl-1,2-ethandiamin, 4-Methylpyridin, 3-Methyl-1-hexanamin, Nitril, Acetonitril, Decannitril, Ether, Dioxan, Tetrahydrofuran, ionische Flüssigkeiten, 1-n-Butyl-3-methylimidazoliumchlorid, 1-Ethyl-3-methylimizadoliumtetrafluoroborat, Lösungsmittel mit Mischungen funktioneller Gruppen, Diacetonalkohol, Ethylacetoacetat, Ethylpyruvat und Kombinationen davon, vorzugsweise Dimethylformamid, Dimethylacetamid, Cyclohexanon, γ-Butyrolacton, Dimethylsulfoxid, N-Methyl-2-pyrrolidon oder Kombinationen davon und noch bevorzugter N-Methyl-2-pyrrolidon, Dimethylsulfoxid oder ein Gemisch davon, vorzugsweise unter Rühren;
c) organische Quellung der geschnittenen PCBs mit einem organischen Lösungsmittel , ausgewählt aus der folgenden Liste: Amide, Dimethylformamid, Dimethylacetamid, Hexamethylphosphoramid, Ketone, Methylethylketon, Cyclohexanon, Cyclopentanon, Aceton, Lactone, γ-Butyrolacton, γ-Caprolacton, γ-Valerolacton, ε-Caprolacton, Sulfoxide, Dimethylsulfoxid, Diethylsulfoxid, Lactamen, N-Methylpyrrolidon, N-Ethylpyrrolidon, N-Propylpyrrolidon, N-Buthylpyrrolidon, Carbonsäuren, Essigsäure, Sulfonsäuren, Methansulfonsäure, Alkohole, Tetrahydrofurfurylalkohol, Propan-2-ol, Butan-1-ol, Ethanol, Ester, Dimethylmalonat, Ethylacetat, Butylacetat, Terzbutylacetat, Methylethansulfonat, aromatische Lösungsmittel, Phenol, Benzol, m-Kresol, N,N-Difluorbenzol, Amine, Pyridin, N,N'-Diethyl-1,2-ethandiamin, 4-Methylpyridin, 3-Methyl-1-hexanamin, Nitril, Acetonitril, Decannitril, Ether, Dioxan, Tetrahydrofuran, ionische Flüssigkeiten, 1-n-Butyl-3-methylimidazoliumchlorid, 1-Ethyl-3-methylimizadoliumtetrafluoroborat, Lösungsmittel mit Mischungen funktioneller Gruppen, Diacetonalkohol, Ethylacetoacetat, Ethylpyruvat und Kombinationen davon, vorzugsweise Dimethylformamid, Dimethylacetamid, Cyclohexanon, γ-Butyrolacton, Dimethylsulfoxid, N-Methyl-2-pyrrolidon oder Kombinationen davon und noch bevorzugter N-Methyl-2-pyrrolidon, Dimethylsulfoxid oder ein Gemisch davon, in einem Niederdruckreaktor, wobei der Druck 1 bis 10 atm beträgt, unter Erhitzen und Rühren, wodurch ein Gemisch erhalten wird;
d) Fest-Flüssig-Trennung des Gemischs, wobei die feste Fraktion des Gemischs, die die metallische und die nichtmetallische Fraktion umfasst, gegebenenfalls einem Trocknungsschritt unterzogen wird;
e) Trennen von Gold aus den metallischen und nichtmetallischen Fraktionen durch magnetische Trennung;
f) und Siebung.

2. Verfahren nach Anspruch 1, wobei das Verhältnis der PCBs:Lösungsmittel 1:10 g/ml, vorzugsweise 1:5 g/ml, noch bevorzugter 1:3 g/ml und noch bevorzugter 1:2 g/ml beträgt.

3. Verfahren nach einem der vorhergehenden Ansprüche, wobei das Gold aus Goldfingern besteht.

4. Verfahren nach einem der vorhergehenden Ansprüche, wobei das mechanische Verfahren eine Guillotine, ein rotierendes Messer, eine Schleifmaschine oder eine andere geeignete Schneidvorrichtung umfasst.

5. Verfahren nach einem der vorhergehenden Ansprüche, wobei das Rühren in Schritt b zwischen 15 und 20 Stunden, vorzugsweise 17 Stunden, durchgeführt wird.

6. Verfahren nach einem der vorhergehenden Ansprüche, wobei der Schritt der Durchführung einer organischen Quellung in dem Niederdruckreaktor in weniger als einer Stunde, bevorzugter in weniger als 45 Minuten, noch bevorzugter in weniger als 30 Minuten und noch bevorzugter in 20 Minuten durchgeführt wird.

7. Verfahren nach einem der vorhergehenden Ansprüche, wobei der Schritt der Durchführung einer organischen Quellung in einem Niederdruckreaktor bei einer Rührgeschwindigkeit von 400 bis 1200 U/min, vorzugsweise von 600 bis 1000 U/min, durchgeführt wird.

8. Verfahren nach einem der vorhergehenden Ansprüche, wobei der Schritt der Durchführung einer organischen Quellung in einem Niederdruckreaktor bei einer Temperatur von 40 °C bis 300 °C, vorzugsweise von 60 °C bis 250 °C, durchgeführt wird.

9. Verfahren nach einem der vorhergehenden Ansprüche, wobei der Siebschritt mit Sieben von 0,5 bis 5 mm, vorzugsweise von 0,7 bis 2 mm, durchgeführt wird.

10. Verfahren nach einem der vorhergehenden Ansprüche, umfassend einen zusätzlichen Schritt des elektrostatischen Trennverfahrens zur Isolierung von unedlen Metallen, vorzugsweise Kupferfolien, aus der nichtmetallischen Fraktion.

11. Verfahren nach einem der vorhergehenden Ansprüche, wobei der Schritt des Trennens der nichtmetallischen von den metallischen Fraktionen der PCBs durch Trennung von polymeren Komponenten von nichtmetallischen laminierten Schichten durchgeführt wird, wobei die metallischen Komponenten Goldfinger, Kupferlaminate oder Kombinationen davon sind.

12. Verfahren nach einem der vorhergehenden Ansprüche, wobei die Rückgewinnung an Goldfingern über 80 %, vorzugsweise über 90 % und noch bevorzugter über 95 % beträgt.

## Revendications

1. Procédé de récupération de l'or des cartes de circuits imprimés (PCB) comprenant les étapes suivantes :
a) couper les terminaux des PCB comprenant une fraction métallique et une fraction non métallique à l'aide d'un procédé mécanique, où la coupe est effectuée sur les terminaux de connexion des PCB ;
b) optionnellement, placer les terminaux de connexion des PCB coupés dans un processus de pré-gonflement avec un solvant organique choisi dans la liste suivante : amides, diméthylformamide, diméthylacétamide, hexaméthylphosphoramide, cétones, méthyléthylcétone, cyclohexanone, cyclopentanone, acétone, lactones, γ-butyrolactone, γ-caprolactone, γ-valérolactone, ε-caprolactone, sulfoxydes, diméthylsulfoxyde, diéthylsulfoxyde, lactames, N-méthylpyrrolidone, N-éthylpyrrolidone, N-propylpyrrolidone, N-butylpyrrolidone, acides carboxyliques, acide acétique, acides sulfoniques, acide méthanesulfonique, alcools, alcool tétrahydrofurfurylique, propan-2-ol, butan-1-ol, éthanol, esters, malonate de diméthyle, acétate d'éthyle, acétate de butyle, acétate de tert-butyle, méthyléthanesulfonate, solvants aromatiques, phénol, benzène, m-crésol, N,N-difluorobenzène, amines, pyridine, N,N'-diéthyl-1,2-éthanediamine, 4-méthylpyridine, 3-méthyl-1-hexanamine, nitrile, acétonitrile, décane nitrile, éthers, dioxane, tétrahydrofurane, liquides ioniques, chlorure de 1-n-butyl-3-méthylimidazolium, 1-éthyl-3-méthylimizadolium tétrafluoroborate, solvants avec des mélanges de groupes fonctionnels, diacétone alcool, acétoacétate d'éthyle, pyruvate d'éthyle et leurs combinaisons, de préférence diméthylformamide, diméthylacétamide, cyclohexanone, γ-butyrolactone, diméthylsulfoxyde, N-méthyl-2-pyrrolidone ou leurs combinaisons et, de préférence encore, N-méthyl-2-pyrrolidone, diméthylsulfoxyde ou un mélange de ceux-ci, de préférence sous agitation ;
c) effectuer un gonflement organique des PCB coupés avec un solvant organique choisi dans la liste suivante : amides, diméthylformamide, diméthylacétamide, hexaméthylphosphoramide, cétones, méthyléthylcétone, cyclohexanone, cyclopentanone, acétone, lactones, γ-butyrolactone, γ-caprolactone, γ-valérolactone, ε-caprolactone, sulfoxydes, diméthylsulfoxyde, diéthylsulfoxyde, lactames, N-méthylpyrrolidone, N-éthylpyrrolidone, N-propylpyrrolidone, N-butylpyrrolidone, acides carboxyliques, acide acétique, acides sulfoniques, acide méthanesulfonique, alcools, alcool tétrahydrofurfurylique, propan-2-ol, butan-1-ol, éthanol, esters, malonate de diméthyle, acétate d'éthyle, acétate de butyle, acétate de tert-butyle, méthyléthanesulfonate, solvants aromatiques, phénol, benzène, m-crésol, N,N-difluorobenzène, amines, pyridine, N,N'-diéthyl-1,2-éthanediamine, 4-méthylpyridine, 3-méthyl-1-hexanamine, nitrile, acétonitrile, décane nitrile, éthers, dioxane, tétrahydrofurane, liquides ioniques, chlorure de 1-n-butyl-3-méthylimidazolium, 1-éthyl-3-méthylimizadolium tétrafluoroborate, solvants avec des mélanges de groupes fonctionnels, diacétone alcool, acétoacétate d'éthyle, pyruvate d'éthyle et leurs combinaisons, de préférence diméthylformamide, diméthylacétamide, cyclohexanone, γ-butyrolactone, diméthylsulfoxyde, N-méthyl-2-pyrrolidone ou leurs combinaisons et, de préférence encore, N-méthyl-2-pyrrolidone, diméthylsulfoxyde ou un mélange de ceux-ci, dans un réacteur à basse pression, où la pression est comprise entre 1 et 10 atm, avec chauffage et agitation, obtenant ainsi un mélange ;
d) séparation solide-liquide du mélange, la fraction solide du mélange comprenant les fractions métallique et non métallique étant soumise à une étape de séchage optionnelle ;
e) séparation de l'or des fractions métalliques et non métalliques par séparation magnétique;
f) et tamisage.

2. Procédé selon la revendication 1, dans lequel le rapport PCB:solvant est de 1:10 g/mL, de préférence 1:5 g/mL, plus préférentiellement 1:3 g/mL et encore plus préférentiellement 1:2 g/mL.

3. Procédé selon l'une quelconque des revendications précédentes, dans lequel ledit or sont des connecteurs or.

4. Procédé selon l'une quelconque des revendications précédentes, dans lequel le procédé mécanique comprend une guillotine, un couteau rotatif, un broyeur ou tout autre appareil de coupe approprié.

5. Procédé selon l'une quelconque des revendications précédentes, dans lequel l'agitation à l'étape b est effectuée entre 15 heures et 20 heures, de préférence pour 17 heures.

6. Procédé selon l'une quelconque des revendications précédentes, dans lequel l'étape de réalisation d'un gonflement organique dans le réacteur à basse pression est effectuée en moins d'une heure, plus préférentiellement en moins de 45 minutes, encore plus préférentiellement en moins de 30 minutes et encore plus préférentiellement en 20 minutes.

7. Procédé selon l'une quelconque des revendications précédentes, dans lequel l'étape de réalisation d'un gonflement organique dans un réacteur à basse pression est effectuée à une vitesse d'agitation comprise entre 400 et 1200 tours/minute, de préférence entre 600 et 1000 tours/minute.

8. Procédé selon l'une quelconque des revendications précédentes, dans lequel l'étape de réalisation d'un gonflement organique dans un réacteur à basse pression est effectuée à une température comprise entre 40 °C et 300 °C, de préférence entre 60 °C et 250 °C.

9. Procédé selon l'une quelconque des revendications précédentes, dans lequel l'étape de tamisage est effectuée avec des tamis de 0,5 à 5 mm, de préférence de 0,7 à 2 mm.

10. Procédé selon l'une quelconque des revendications précédentes comprenant une étape supplémentaire de procédé de séparation électrostatique pour isoler les métaux de base, de préférence les feuilles de cuivre, de la fraction non métallique.

11. Procédé selon l'une quelconque des revendications précédentes, dans lequel l'étape consistant à séparer les fractions non métalliques des fractions métalliques des PCB est effectuée en séparant les composants polymères des couches stratifiées non métalliques, les composants métalliques étant des connecteurs or, des stratifiés de cuivre ou des combinaisons de ceux-ci.

12. Procédé selon l'une quelconque des revendications précédentes, dans lequel le rendement de récupération des connecteurs or est supérieur à 80 %, de préférence supérieur à 90 % et plus préférentiellement supérieur à 95 %.
